(19) Europäisches Patentamt

European Patent Office

Office européen des brevets

(11) Publication number: **0 049 791**

**B1**

(12) **EUROPEAN PATENT SPECIFICATION**

(45) Date of publication of patent specification: **12.06.85**

(51) Int. Cl.⁴: **H 01 L 23/36**

(21) Application number: **81107622.3**

(22) Date of filing: **24.09.81**

(54) Semiconductor device with a heat dissipating substrate.

(30) Priority: **24.09.80 JP 134737/80 u**

(43) Date of publication of application:
**21.04.82 Bulletin 82/16**

(45) Publication of the grant of the patent:
**12.06.85 Bulletin 85/24**

(84) Designated Contracting States:
**DE NL**

(56) References cited:
**EP-A-0 009 978**
**DE-A-2 218 169**
**DE-A-2 649 704**
**DE-A-2 824 250**

(73) Proprietor: **Hitachi, Ltd.**
**5-1, Marunouchi 1-chome**
**Chiyoda-ku Tokyo 100 (JP)**

(72) Inventor: **Chiba, Akio**
**3808-91, Ogitsu Hitachi**
**Ibaraki (JP)**
Inventor: **Shimizu, Seiki**
**2662-68, Kanesawa Hitachi**
**Ibaraki (JP)**
Inventor: **Kuniya, Keiichi**
**1-24-10, Nishinarusawa Hitachi**
**Ibaraki (JP)**
Inventor: **Onuki, Zin**
**1-6-1, Kuji Hitachi**
**Ibaraki (JP)**

(74) Representative: **Strehl, Peter, Dipl.-Ing. et al**
**Strehl, Schübel-Hopf, Schulz Patentanwälte**
**Widenmayerstrasse 17 Postfach 22 03 45**
**D-8000 München 22 (DE)**

Courier Press, Leamington Spa, England.

## Description

### Background of the invention

This invention relates to a semiconductor device such as power transistors, power modules, integrated circuit devices, and more particularly to a semiconductor device which includes a heat spreading, electro-conductive substrate composed of a copper-carbon fiber composite material for carrying a semiconductor chip or pellet.

Semiconductor devices are generally constructed by a semiconductor chip or pellet having at least one p-n-junction therein bonded on a heat spreading substrate. In power modules or integrated circuit devices there are provided one or more semiconductor chips or pellets on the heat spreading substrate bonded on the insulating substrate, one or more heat spreading substrates being supported on a heat radiating substrate. In order to avoid the breakage of semiconductor pellets which are brittle, it is necessary that the heat spreading substrate should have a thermal expansion coefficient close to that of semiconductor material.

A Cu-carbon fiber composite material formed by embedding carbon fibers in Cu matrix is excellent in heat conductivity and a small thermal expansion coefficient close to that of silicon. Therefore, the Cu-carbon fiber composite material can be substituted for molybdenum or tungsten electrode.

From DE—A—28 24 250 a Cu-carbon fiber composite material having a carbon fiber content of 10—55% by volume is known for use in electrodes of semiconductor devices.

An integrated circuit device having the heat radiating substrate consisting of the Cu-carbon fiber composite material is disclosed in EP—A1—009978 entitled "Integrated Circuit Device", laid open for public inspection on April 16, 1980. In this document a heat spreading substrate is disclosed, wherein individual Cu-plated carbon fibers are arranged in parallel and in a cross array.

### Summary of the invention

One object of the present invention is to provide a semiconductor device having an improved heat conductive substrate or electrode of copper-carbon fiber composite material.

Another object of the present invention is to provide a semiconductor device having a heat spreading substrate or electrode which is capable of protecting a semiconductor chip or pellet from mechanical damage.

The present invenion is featured by a semiconductor device comprising a single or a plurality of semiconductor elements 7 soldered onto a heat spreading substrate 5a, 5b made of a Cu-carbon fiber composite material wherein Cu-plated carbon fibers are grouped to a bundle, having carbon fiber bundles 11, 12, each consisting of 500 to 6000 of flexible carbon fibers 9 arranged in parallel with the end faces of the substrate and in a cross array, which bundles intersect each other to constitute a network with at least 4.6 cross points/cm$^2$ (30 cross points/in$^2$).

The Cu-carbon fiber composite material has areas defined by at least 4 cross points, each of said areas being smaller than the area of said semiconductor.

The Cu-carbon fiber composite material has a carbon fiber content of 10 to 70% by volume. The thickness of the substrate may vary over a wide range; however, when the substrate is used as a heat spreading substrate for modules or integrated circuit devices, its thickness may be selected within the range of 0.05 to 10 mm. On the other hand, when the substrate is used as an electrode for discrete semiconductor devices such as power transistors, diodes, etc., its thickness may be selected within the range of 5 to 50 mm.

Copper powder or a metal powder having a higher conductivity than copper may be packed in the gap portions defined by groups or bundles of fibers which cross each other.

Thus semiconductor of the present invention preferably employs carbon fibers for the Cu-carbon fiber composite material having a diameter of about 10 μm or less.

In the semiconductor device of the present invention carbon fibers of the Cu-carbon fiber composite material may have a weaving structure of plain fabrics, satin, or any other weaving structures.

In one embodiment of the semiconductor device of the present invention the heat spreading substrate is fixed on an insulating material.

In another embodiment of the semiconductor device of the present invention the insulating material is fixed on a heat radiating substrate of the Cu-carbon fiber composite material.

### Brief description of the drawings

Figure 1 is a sectional view of an integrated circuit device in accordance with an embodiment of the present invention;

Figure 2 is a diagram showing the relationship between the thermal expansion coefficient and the carbon fiber content in a Cu-carbon fiber composite material;

Figure 3 is a diagram showing the relationship between the thermal expansion coefficient and the fiber array of a Cu-C fiber composite material having a carbon fiber content of 54 vol.%, the thermal expansion coefficient being measured at 25 to 250°C;

Figure 4 is an enlarged section view of a crossing point of the Cu-carbon fiber net in the cross array (weaved in plain fabrics) in a heat spreading substrate in accordance with the present invention;

Figure 5 is a plane view of the Cu-carbon fiber net in the cross array in a heat spreading substrate in accordance with the present invention;

Figure 6 is a plane view of the Cu-carbon fiber net in the cross array in accordance with another embodiment of the present invention;

Figure 7 is a diagram showing the relationship between the thermal expansion coefficient and the number of cross points in the Cu-carbon fiber net of the heat spreading substrate or wiring film in accordance with the present invention; and

Figure 8 is a diagram showing the relationship between the thermal expansion coefficient in the longitudinal or transverse direction, as viewed from the front, and the size of a square of heat spreading substrate having wiring films made from Cu-C nets having 3.1 cross points/cm² (20 cross points/in²) and 4.6 cross points/cm² (30 cross points/in²) hot-pressed and cut into small pieces.

Description of the preferred embodiment

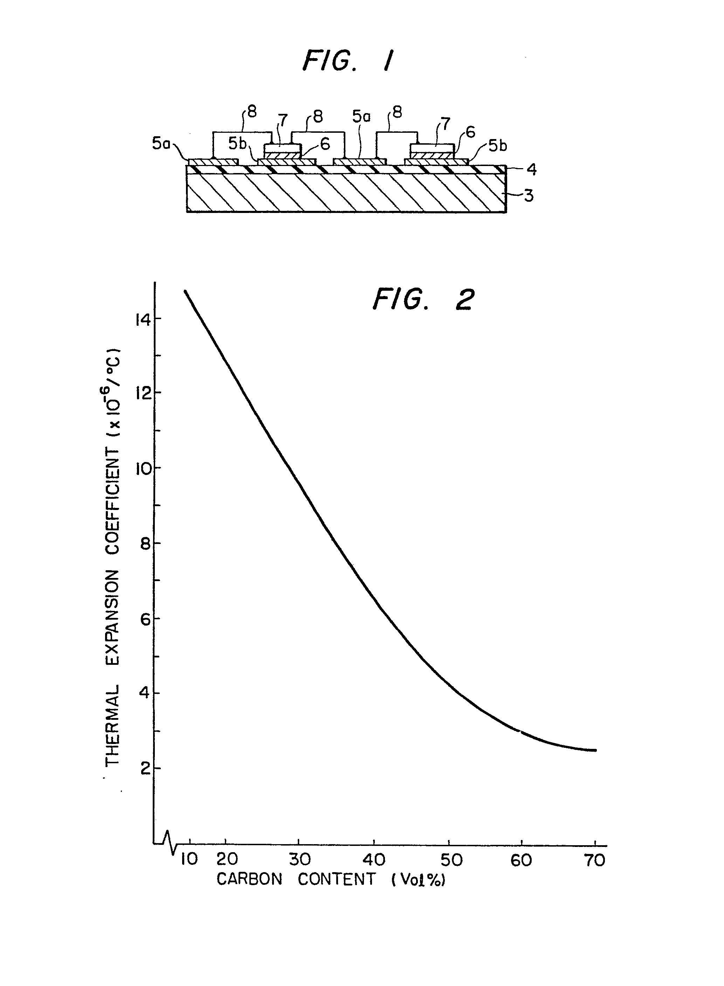

Referring to Figure 1, in the integrated circuit device in accordance with the present invention, an insulating substrate 4 of alumina is disposed on a heat radiating substrate 3 and heat spreading substrate having wiring films 5a, 5b are disposed on the aluminum insulating substrate 4. Circuit elements for forming a predetermined circuit network are electrically connected to copper films or solder films formed on the heat spreading substrate of Cu-carbon fiber composite material. The circuit elements include semiconductor elements 7 on a Cr-Ni-Ag alloy layer 6 and lead wires 8. Heat generated in the semiconductor elements is easily spreaded to protect the element from thermal damage.

The heat radiating substrate 3 and substrates having the wiring films 5a, 5b (hereinafter referred to as the "heat spreading substrate") can be constructed by a Cu-carbon fiber composite material.

The inventors of the present invention have succeeded in accomplishing the objects of the present invention by suitably selecting the array or arrangement in the Cu-carbon fiber composite material for making the thermal expansion coefficient of the composite material close to that of the semiconductor material.

The carbon fibers used in the present invention are previously coated with copper.

In the bidirectional array, the Cu-carbon fibers are knitted so as to cross one another both longitudinally and transversely. In this array, the tension applied to each fiber material appears as a restrictive force that occurs at the cross point of each fiber. However, this restrictive force is not sufficient to prevent the Cu coating from extending due to the difference between the thermal expansion of Cu and carbon fiber. Consequently, when the bidirectional array Cu-carbon fiber composite material is caused to effect sintering of the copper coated carbon fibers stick and adhere to each other to produce a dense, integral Cu-carbon fiber composite material at a temperature lower than the melting point of copper.

After being hot-worked, the Cu-carbon fiber composite material is cut in a suitable size and shape. e.g. a square 5 to 10 mm on a side, for bonding to the insulating substrate, for example. However, the thermal expansion coefficient of the Cu-carbon fiber composite material changes during this cutting work because the thermal expansion coefficient of Cu is no longer restricted by the abovementioned tension between the carbon fibers after they are cut, if there is no cross point of carbon fibers in the small square.

When a pellet of semiconductor material is bonded on the heat spreading substrate or electrode of the Cu-carbon fiber composite material, the area of the semiconductor should preferably be larger than the area defined by 4 cross points constituted by carbon fibers.

As seen in Figure 2, the thermal expansion coefficient of the Cu-carbon fiber composite material as the heat spreading substrate can be adjusted by adjusting its carbon fiber content. In other words, if a Cu-carbon fiber composite material having a suitable carbon fiber content is selected, its thermal expansion coefficient can be adjusted to those of the semiconductor element and an insulating substrate. Experiments carried out by the inventors of the present invention have revealed that no practical problems occur if the carbon fiber content is from 10 to 70% by volume.

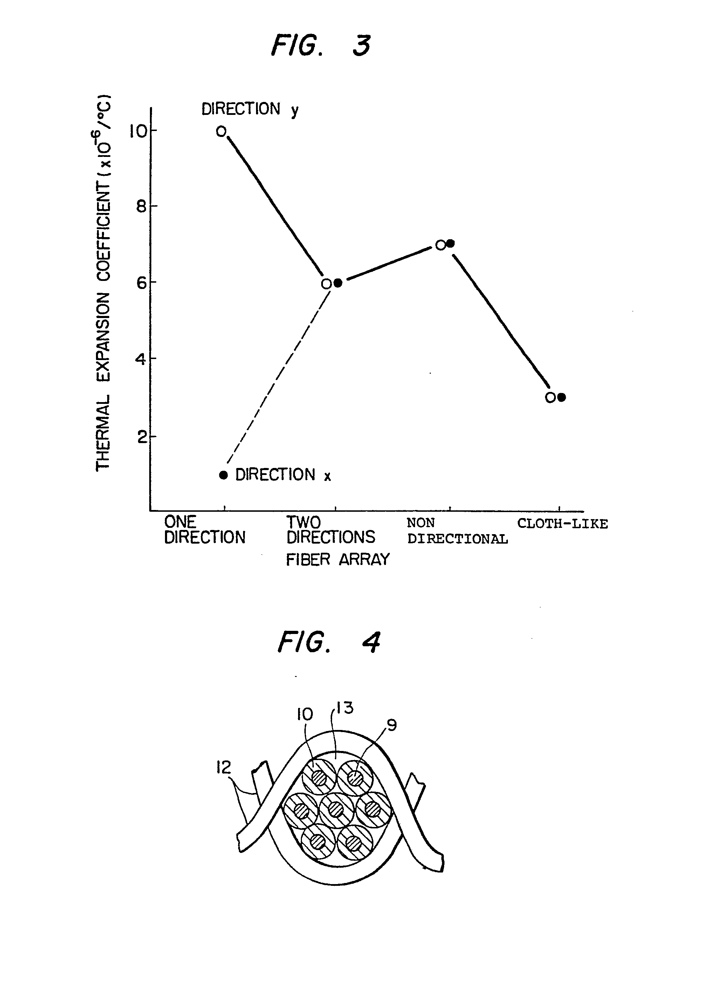

It can be understood from Figure 3 that a heat spreading substrate having a low thermal expansion coefficient can be obtained by suitably selecting the fiber array of the Cu-carbon fiber composite material. In Figure 3, the phrase "two directions" means that carbon fibers are not woven but simply stacked or imposed in two directions.

Though various fiber arrays may be possible for the Cu-carbon fiber composite material as described already, a cloth form such as a plain weave is suitable for the heat spreading substrate from the aspects of productivity. It is possible to constitute the cross points by arranging one or more layers of carbon fibers oriented in one direction with one or more layers of carbon fibers oriented in another direction (e.g. 90°).

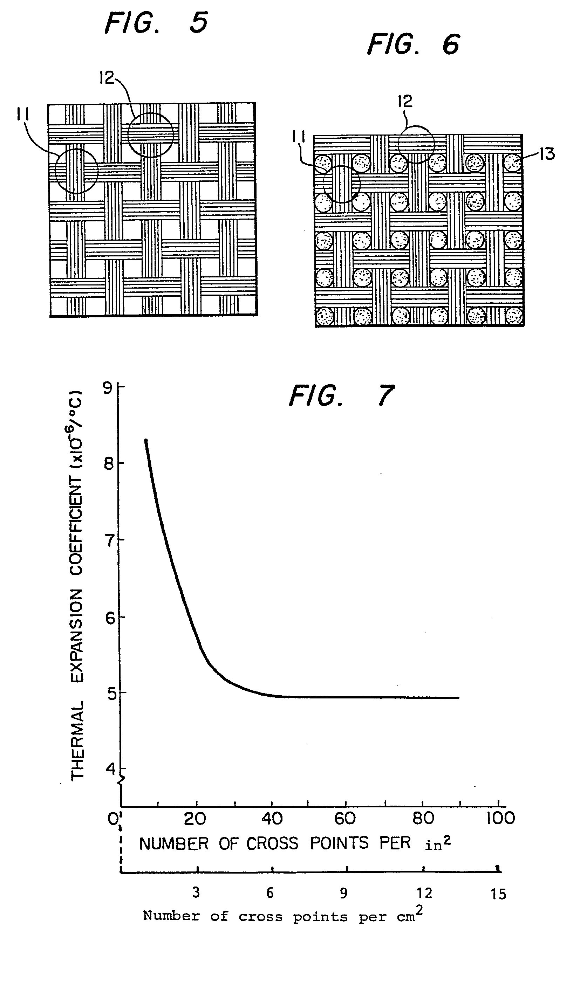

When the Cu-carbon fiber composite material is arranged in the cross array, is sintered by a hot-pressing and is then cut to produce the heat spreading substrate for integrated circuit devices, the thermal expansion coefficient of the resulting heat spreading substrate becomes constant if it is at least a certain minimum size. This is determined by the number of cross points of the heat spreading substrate as will become apparent from a later description in conjunction with Figure 7.

The crystal structure of the C fiber is a hexagonal system with the carbon axis in the radial direction. The thermal expansion coefficient in the radial direction of the carbon fiber becomes as great as $17 \sim 18 \times 10^{-6}$/°C. To obtain the thermal expansion coefficient in the two directions of the Cu-C fiber composite, the present invention makes use of a small thermal expansion coefficient such as $-2 \times 10^{-6}$/°C of the carbon fiber in the longitudinal direction and adjusts the carbon fiber content to 10 to 70 vol.% in order to offset the elongation of the copper coating in the longitudinal direction due to the temperature increase by means of the restriction force of the carbon fiber in its longitudinal direction. The restriction force is multiplied by forming at least 4 cross points in the heat spreading substrate on which one or more semiconductor chips are bonded.

As diagrammatically shown in Figure 4 through 6, each of fiber bundles 11, 12 consists of 500 to 6000, preferably 1000 to 3000 carbon fibers 9 having a diameter of about 10 μm or less with a Cu plating 10 of 0.5 to 3 μm applied to it. Tension of 0.5 to 5N is applied to each fiber bundle 11, 12 during weaving a Cu-Carbon network, whereby the thermal expansion of the carbon fiber in the parallel with the carbon fibers oriented direction is restricted. The term "cross point" herein denotes the points of intersection between the fiber bundles. It is needless to say that the bundles or group of fine, flexible carbon fibers may simply be stacked in a manner to form the above mentioned network.

The difference between Figures 5 and 6 is that a metal having a high heat conductivity such as Cu powder or Ag powder is packed into gap portions 13 in Figure 6 to increase heat conductivity of the substrate whereas the metal powder is not packed in Figure 5.

In the Cu-C net composite shown in Figure 6, the metal powder is first prepared in a slurry form and is then coated on the Cu-C net, and a pressure of 100 to 500 bar is applied in order to sufficiently pack the metal powder into the gaps in the net. The Cu-C net produced in this manner is subjected to a reducing treatment in a hydrogen atmosphere.

The Cu-C nets shown in Figures 5 and 6 are heated to effect sintering at a temperature below the melting point of copper, such as 900 to 1,050°C in a hydrogen atmosphere under a pressure of 200 to 300 bar.

Example

A Cu-carbon fiber net composite shown in Figure 5 was produced by plain weave having the same number of cross points using Cu-carbon fibers consisting of carbon fibers of 7 μm, each being plated with copper so that the total copper volume was up to 70 vol.% based on the whole volume of the copper plated carbon fibers. The Cu-carbon fiber net composite was subjected to reducing treatment at 400°C for 30 minutes in hydrogen in order to remove oxides. After the reducing treatment, the Cu-carbon fiber net composite was sintered at 1000°C for 30 minutes under a pressure of 250 bar to produce a Cu-carbon fiber composite substrate.

Thus, Cu-carbon fiber substrates having 1.4, 2.5, 3.9, 5.6, 12.5 cross points/cm$^2$ (9, 16, 25, 36 and 81 cross points/in$^2$) were produced. The thermal expansion coefficient of each sample was measured and the results are shown in Figure 7.

As is obvious from Figure 7, the thermal expansion coefficient increases with a decreasing number of cross points and no change occurs in the thermal expansion coefficient in the samples having 4.6 cross points/cm$^2$ (30 cross points/in$^2$) or more.

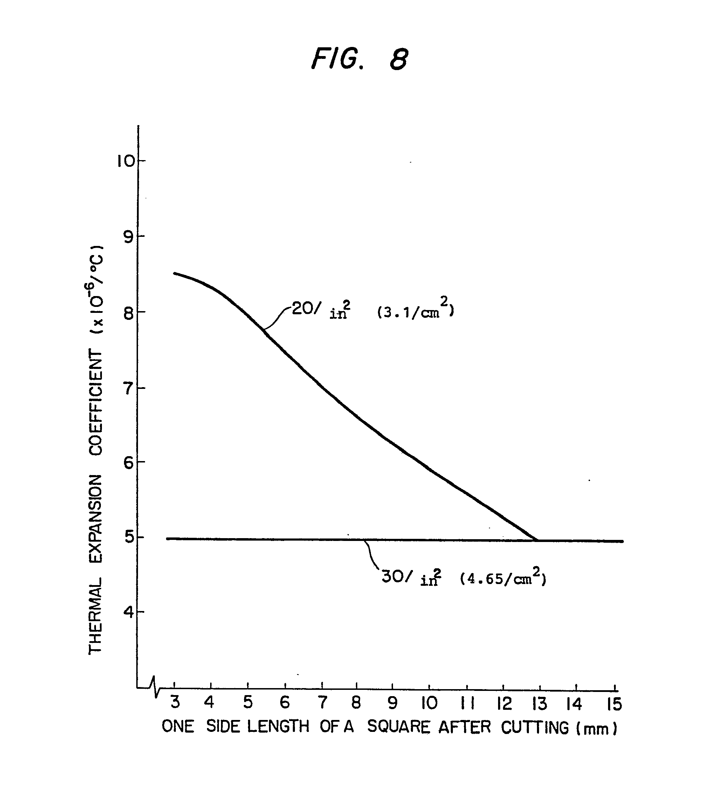

Cu-carbon fiber substrates (50mm×50mm) having the same specifications as that of the element shown in Figure 7 and produced so as to contain 3.1 cross points/cm$^2$ (20 cross points/in$^2$) and 4.6 cross points/cm$^2$ (30 cross points/in$^2$), respectively, were cut into squares with sides of 3, 5, 7, 10 and 13 mm, and the thermal expansion coefficient of each sample was measured with the result shown in Figure 8. As the measuring condition, each sample was cut, then annealed to remove strain (400°C for 0.5 hr) and was subjected to the measurement between 25°C and 250°C.

It can be seen from Figure 8 that in the samples having 3.1 cross points/cm$^2$, (20 cross points/in$^2$), the thermal expansion coefficient increases with decreasing size and the variance also becomes great.

In the samples having 4.6 cross points/cm$^2$ (30 cross points/in$^2$), on the other hand, the thermal expansion coefficient remains unchanged even if the cut size is changed and hence, stable Cu-carbon fibers substrates can be obtained.

When the samples whose thermal expansion coefficient did not change were cut into arbitrary shapes and their thermal expansion coefficients were measured, no change could be observed in the thermal expansion coefficient.

Under the same condition as in the above-mentioned example, substrates were produced from Cu-carbon fibers having the carbon fiber contents of 54, 45 and 35 vol.%, respectively and in some cases Cu powder was packed into the gap portions defined by 4 cross points of carbon fiber bundles. The heat conductivity and thermal expansion coefficient of each of the substrates thus produced were measured and the results are shown in the table below.

| | Cu powder not packed (Fig. 5) | | Cu powder packed (Fig. 6) | |
|---|---|---|---|---|
| C vol.% | w/cm°C | ×10$^{-6}$/°C | w/cm°C | ×/10$^{-6}$/°C |
| 54 | 1.5 | 5 | 2 | 7 |
| 45 | 2 | 7 | 2.5 | 9 |
| 35 | 2.5 | 9 | 3 | 10 |

When the surface of the Cu-carbon fiber substrates was observed, it was found that expansion of the carbon fiber was less in those in which Cu powder was packed into the gap portions. With reference to the above-mentioned embodiment, the substrates having the Cu powder packed into the gap portions of the Cu-carbon fiber net composite had improved heat conductivity. For, Cu heat pipes penetrating through the Cu-carbon fiber net composite was formed in the section of the net, thereby improving the heat conductivity. When the heat spreading substrate was made of Mo, the heat conductivity was 1.5w/cm²°C and the thermal expansion coefficient was $5.1 \times 10^{-6}$/°C.

The present invention can also be used in combination with radiating substrate 3 such as shown in Figure 1.

## Claims

1. A semiconductor device comprising a single or a plurality of semiconductor elements (7) soldered onto a heat spreading substrate (5a, 5b) made of a Cu-carbon fiber composite material wherein Cu-plated carbon fibers are grouped to a bundle, characterized in that carbon fiber bundles (11, 12), each consisting of 500 to 6000 of flexible carbon fibers (9) are arranged in parallel with the end faces of the substrate and in a cross array, which bundles intersect each other to constitute a network with at least 4.6 cross points/cm² (30 cross points/in²).

2. The semiconductor device as defined in claim 1, characterized in that said Cu-carbon fiber composite material has areas defined by at least 4 cross points, each of said areas being smaller than the area of said semiconductor.

3. The semiconductor device as defined in claim 1, characterized in that said Cu-carbon fiber composite material has a carbon fiber content of 10 to 70% by volume.

4. The semiconductor device as defined in claim 1, characterized in that copper powder, or a metal powder having a higher heat conductivity than that of copper is packed in gap portions (13) between said Cu-carbon fiber bundles (11, 12) of said Cu-carbon fiber composite material.

5. The semiconductor device as defined in claim 1, characterized in that said carbon fibers of said Cu-carbon fiber composite material have a diameter of 7 μm.

6. The semiconductor device as defined in claim 1, characterized in that carbon fibers of said Cu-carbon fiber composite material have a weaving structure of plain fabrics.

7. The semiconductor device as defined in claim 1, characterized in that said heat spreading substrate (5a, 5b) is fixed on an insulating material (4).

8. The semiconductor device as defined in claim 7, characterized in that said insulating material (4) is fixed on a heat radiating substrate (3) of the Cu-carbon fiber composite material.

## Revendications

1. Dispositif à semi-conducteurs comprenant un seul ou plusieurs éléments semi-conducteurs (7) soudés sur un substrat (5a, 5b) diffusant la chaleur constitué d'un matériau composite Cu-fibres de carbone dans lequel des fibres de carbone revêtues de Cu sont rassemblées en un faisceau, caractérisé en ce que des faisceaux de fibres de carbone (11, 12) chacun constitué de 500 à 6000 fibres de carbone souples (9) sont agencés parallèlement aux faces d'extrémité du substrat et selon un quadrillage perpendiculaire, ces faisceaux se coupant les uns les autres en formant un réseau comportant au moins 4,6 intersections/cm².

2. Dispositif à semi-conducteurs selon la revendication 1, caractérisé en ce que ledit matériau composite Cu-fibres de carbone présente des surfaces définies par au moins quatre points d'intersection, chacune desdites surfaces étant plus petite que la surface dudit semiconducteur.

3. Dispositif à semi-conducteurs selon la revendication 1, caractérisé en ce que ledit matériau composite Cu-fibres de carbone a une teneur en fibres de carbone de 10 à 70% en volume.

4. Dispositif à semi-conducteurs selon la revendication 1, caractérisé en ce que de la poudre de cuivre ou une poudre de métal ayant une conductivité thermique supérieure à celle du cuivre est introduite dans les interstices (13) séparant lesdits faisceaux de Cu-fibres de carbone (11, 12) dudit matériau constitué de Cu-fibres de carbone.

5. Dispositif à semi-conducteur selon la revendication 1, caractérisé en ce que lesdites fibres de carbone dudit matériau composite de Cu-fibres de carbone ont un diamètre de 7 μm.

6. Dispositif à semi-conducteur selon la revendication 1, caractérisé en ce que les fibres de carbone dudit matériau composite de Cu-fibres de carbone ont une structure tissée identique à celle des tissus habituels.

7. Dispositif à semi-conducteur selon la revendication 1, caractérisé en ce que ledit substrat (5a, 5b) diffusant la chaleur est fixé sur un matériau isolant (4).

8. Dispositif à semi-conducteur selon la revendication 7, caractérisé en ce que ledit matériau isolant (4) est fixé sur un substrat rayonnant la chaleur (3) constitué par le matériau composite de Cu-fibres de carbone.

## Patentansprüche

1. Halbleiteranordnung mit einem einzelnen oder einer Anzahl von Halbleiterelementen (7) die auf einem Wärme zerstreuenden Substrat (5a, 5b) aufgelötet sind, welches aus einem Cu-Kohlenstoffaser-Verbundmaterial besteht, wobei Cu-plattierte Kohlenstoffasern zu einem Bündel zusammengestellt sind, dadurch gekennzeichnet, daß die Kohlenstoffaser-Bündel (11, 12), die jeweils aus 500 bis 6.000 flexiblen Kohlenstoffasern (9) bestehen, parallel zu den Endflächen des Substrates und in überkreuzender Anordnung angeordnet sind, wobei die Bündel einander zur Bildung eines Netzwerkes überkreuzen, das wenigstens 4,6 Kreuzungspunkte je cm² (30 Kreuzungspunkte je in²) aufweist.

2. Halbleiteranordnung nach Anspruch 1, dadurch gekennzeichnet, daß das Cu-Kohlenstoffaser-Verbundmaterial Flächen aufweist, die durch wenigstens vier Kreuzungspunkte definiert sind, wobei jede dieser Flächen kleiner ist als die Fläche des Halbleiters.

3. Halbleiteranordnung nach Anspruch 1, dadurch gekennzeichnet, daß das Cu-Kohlenstoffaser-Verbundmaterial einen Kohlenstoffaseranteil von 10 bis 70 Vol.-% besitzt.

4. Halbleiteranordnung nach Anspruch 1, dadurch gekennzeichnet, daß Kupferpulver oder ein Metallpulver mit einer höheren Wärmeleitfähigkeit als Kupfer in die Zwischenräume 13 zwischen den Cu-Kohlenstoffaserbündeln (11, 12) des Cu-Kohlenstoffaser-Verbundmaterials gepackt ist.

5. Halbleiteranordnung nach Anspruc1 1, dadurch gekennzeichnet, daß die Kohlenstoffasern des Cu-Kohlenstoffaser-Verbundmaterials einen Durchmesser von 7 µm besitzen.

6. Halbleiteranordnung nach Anspruch 1, dadurch gekennzeichnet, daß die Kohlenstoffasern des Cu-Kohlenstoffaser-Verbundmaterials die Webstruktur eines einfachen Gewebes haben.

7. Halbleiteranordnung nach Anspruch 1, dadurch gekennzeichnet, daß das Wärme zerstreuende Substrat (5a, 5b) an einem isolierenden Material (4) befestigt ist.

8. Halbleiteranordnung nach Anspruch 7, dadurch gekennzeichnet, daß das isolierende Material (4) an einem Wärme abstrahlenden Substrat (3) aus Cu-Kohlenstoffaser-Verbundmaterial befestigt ist.

## FIG. I

## FIG. 2

## FIG. 3

## FIG. 4

## FIG. 5

## FIG. 6

## FIG. 7

NUMBER OF CROSS POINTS PER in²

Number of cross points per cm²

## FIG. 8